# EUROPEAN PATENT SPECIFICATION

(11) **EP 3 511 517 B1**
(45) Date of publication and mention of the grant of the patent: **27.05.2020**
(21) Application number: 18151854.9
(22) Date of filing: 16.01.2018
(51) Int. Cl.: E21B 33/038, H04B 5/00

(54) **SUBSEA HOUSING ASSEMBLY**
UNTERWASSERGEHÄUSEANORDNUNG
ENSEMBLE DE LOGEMENT SOUS-MARIN

(43) Date of publication of application: 17.07.2019
(73) Proprietor: Siemens Aktiengesellschaft, 80333 München (DE)
(72) Inventor: GÖTZ, Jürgen, 91315 Höchstadt/Aisch (DE); LUDWIG, Klaus, 91058 Erlangen (DE)

(56) References cited:
- WO-A1-2014/123425
- WO-A1-2015/139953
- WO-A1-2017/023812
- US-A- 5 455 573

## Description

### TECHNICAL FIELD

The present invention relates to a subsea housing assembly, to a subsea sensor, and to a subsea connector.

### BACKGROUND

Subsea housing assemblies are essential parts of most subsea components such as subsea sensors or subsea connectors. Subsea sensors such as temperature sensors or pressure sensors are often used in subsea processing facilities. Subsea connectors are generally used to connect subsea cable arrangements to subsea devices and are typically exposed to high pressures but are usually not exposed to the same extreme pressures as subsea sensors.

Both subsea sensors and subsea connectors usually form part of a barrier. In the case of a subsea sensor the barrier may be between a process fluid and the seawater, in the case of a subsea connector the barrier may be between the inside of a subsea device and the seawater or between a pressure-compensated chamber and a low pressure chamber, for example a near atmospheric pressure chamber.

A subsea sensor may for example be mounted to a pipe section through which a process fluid flows, such as a gas, a liquid, or a multiphase fluid which can include gaseous, liquid and solid constituents. The process fluid pressure in some applications can be very high, for example in excess of 1,000 or 1,400 bar. While it is important for the process of extracting the process fluid to measure those high pressures with high accuracy it is similarly important to ensure that no process fluid leaks into the seawater under any circumstances. Similarly, for the subsea connector it is important that no seawater enters the subsea device to which the connector is attached and/or that none of the fluid contained inside a pressure compensated subsea device or chamber (often oil) enters into the seawater and/or that no seawater enters a pressure resistant chamber containing pressure sensitive components.

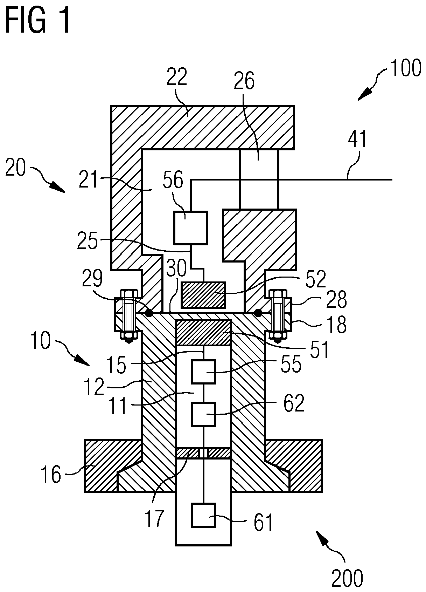

European patent application EP 3269921 discusses a subsea housing assembly having a wall 30 providing a separation between a first housing portion 10 and a second housing portion 20 wherein a data communication is being provided between the first and second housing portions, through said wall, by way of inductive coupling 50 as shown in Fig. 1.

International application publication WO 2017/023812 A1 discloses a transmission system for use above water which includes a flange configured to couple to the side outlet of a wellhead, where the flange includes a base, an exterior annular tapered portion extending from the base, and an annular wall extending from the exterior annular tapered portion, wherein the annular wall defines a central exterior cavity and an interior annular cavity. The system further includes an inductive coupling mounted within the flange comprising first and second components separated by the annular wall.

International application publication WO 2014/123425 A1 discloses a subsea valve for control of fluid that can be contaminating and at elevated pressure and temperature. The valve comprises an actuator unit and a valve part. The actuator unit can be operated in order to control the valve part, distinctive in that the actuator unit is magnetically coupled to the valve part and the coupling is through a barrier wall isolating the actuator unit from the valve part, and the actuator unit and a driving part of the magnetic coupling are arranged in a sealed actuator housing into which leakage of said contaminating fluid thereby has been eliminated.

International application publication WO 2015/139953 A1 discloses a power switching device for operation in an underwater environment. The power switching device has a base unit with a pressure compensated enclosure. The enclosure forms a single base chamber filled with a liquid or gel. A power input and at least a first power output are mounted to the base unit. A pressure resistant wall is mounted to the base unit and separates a base chamber from a switching chamber. Penetrators are arranged in the pressure resistant wall. Input busbars and output busbars are directly connected to the penetrators in the base chamber.

United States Patent US 5,455,573A discloses an inductive coupling device for coaxially arranged tubular members where the members can be telescopically arranged and the liner member has a magnetic core assembly constructed from magnetic iron with cylinder sloped ends and the outer member has an annular magnetic assembly aligned with the core assembly. The tubular members are non-magnetic enclosures and together with a gap spacing define an effective air gap.

It is an object of the present invention to provide a subsea housing assembly and a subsea sensor with an improved inductive coupling, as defined by the appended claims.

### SUMMARY

In accordance with one aspect of the present disclosure there is provided a subsea housing assembly comprising a subsea housing having a first and a second housing portion. The first housing portion comprises a first electrical connection for data communication and the second housing portion comprises a second electrical connection for data communication. A wall provides separation between the first housing portion and the second housing portion. The subsea housing assembly further comprises an inductive coupler comprising a first coupling section disposed in the first housing portion and a second coupling section disposed in the second housing portion. The inductive coupler is configured to provide inductive coupling across the wall for providing at least a data communication between the first electrical connection and the second electrical connection. Guide bodies made of soft magnetic material are provided for collecting and guiding the magnetic flux or field created by the first coupling section to the second coupling section and vice versa.

In a preferred embodiment the wall is a pressure barrier configured to resist a predetermined minimum pressure difference across the wall.

In a preferred embodiment the inductive coupler may further be configured to inductively supply electrical power from the electrical connection in the second housing portion to the electrical connection in the first housing portion.

In a preferred embodiment the first and second coupling sections comprise coils that are arranged concentrically. As an example, the coil in the second housing section may be driven by an AC current that can be modulated for data communication. The resulting electromagnetic field is directed by means of the guide body in the second housing section to the coil in the first coupling section in the first housing portion by means of the guide body in the second housing portion and can induce a current in the first coupling section. It should be noted that the guide body in the first housing section may further facilitate the guiding of the electromagnetic field towards the first coupling section compared to an arrangement having only one guide body. Electrical power and/or data communication signals (which can include control signals) may thus be transferred into the first housing portion. Similarly, a modulated current can be provided to the coil of the first coupling section creating an alternating electromagnetic field which is directed by means of the guide body in the first housing portion to induce a respective current in the second coupling section, for example for transferring sensor data or the like.

In a preferred embodiment the guide bodies may each comprise pot core halves.

In other preferred embodiments the guide bodies may each comprise "E" cores.

In a preferred embodiment the coils are flat PCB coils and the guide bodies are flat.

Depending on the application the first guide body and the second guide body may be differently shaped.

In a preferred embodiment the wall is made of a non-magnetic material, preferably a non-magnetic metal, preferably Iconel 625.

The second housing portion may comprise a pressure compensator providing pressure compensation of the second chamber with the ambient (seawater) pressure. The second housing portion may therefor be connected to a subsea cable in form of a medium filled hose, wherein the second chamber is pressure compensated via the medium filled hose.

In a preferred embodiment the wall may be integrally formed with the first housing body of the first housing portion, wherein the housing body is preferably a single piece metal body. In other embodiments, the first housing portion may comprise a plurality of housing parts, and the housing parts may preferably be sealed to each other by metal seals. It is noted that the expression "single piece metal body" is not meant to be understood in that the housing portion cannot comprise further elements mounted to such single piece metal body. What is meant is that the part of the first housing portion that includes the wall providing the second liquid tight barrier and that is sealed to, e.g., a pipe section (or another part of the first housing portion) is formed integrally from a single piece of material. By combining wall and support structure a safe and reliable second pressure barrier within the subsea housing assembly may thus be obtained which may be capable of withstanding large to very large pressure differences such as between the process fluid pressure and the surrounding ambient pressure.

In accordance with another aspect of the present invention there is provided a subsea sensor comprising a subsea housing assembly in accordance with the present invention and further comprising a sensor element disposed in the first housing portion, wherein the first electrical connection is configured for providing communication with the sensor element, and wherein the second electrical connection is configured to provide at least a sensor output of the subsea sensor.

In accordance with yet another aspect of the present invention there is provided a subsea connector comprising a subsea housing assembly in accordance with the present invention.

By providing a subsea housing assembly with such inductive coupler, a data communication can be established through the wall of the subsea housing without using conventional glass penetrators which require a glass to metal sealing and need to be tested at 2.5 times the operating pressure, requiring the entire sensor to be designed to reliably withstand 2.5 times the operating pressure. With an inductive coupler it should be possible to test at only 1.5 times the operating pressure thereby reducing the design and testing requirements considerably. Additionally, problems associated the manufacture of glass to metal junctions and reduced insulation resistance of such penetrators may be avoided.

In some configurations, a single electrical line may be provided for power supply and data communication, for example by providing a respective modulation on the power line. In other embodiments, separate lines may be provided and may be part of the respective electrical connection, for example dedicated lines for power supply and data communication. In some embodiments, the sensor may only be a passive sensor, and only the electrical power required to read such passive sensor may be transmitted by means of the inductive coupler. In other applications, further electric and/or electronic components may be provided in the first housing portion, for example for operating the sensor element or processing sensor data. The inductive coupler's first and second coupling sections preferably provide inductive coupling for both data communication and power transfer. In other embodiments, the inductive coupler may comprise further coupling sections, for example for separately transferring electrical power and communication signals.

The first housing portion may for example comprise a sensor assembly including diaphragms, such as a process diaphragm and a sensor diaphragm, a sensor element, medium filled channels or the like and may further include a first pressure barrier that provides separation between the pressure prevailing in such medium filled channels and the first chamber. As an example, a process diaphragm may transmit the pressure of the process fluid to such medium (e.g. oil) present in the channels, which in turn applies the pressure to a sensor element. Accordingly, if such first pressure barrier fails and process fluid or process fluid pressure is transmitted into the first chamber, such fluid/pressure can be confined to within the first housing portion by means of the wall which constitutes a second pressure barrier.

The first housing portion may be sealed against a metal body by means of a metal seal, in particular a metal gasket. As an example, the subsea housing assembly may be part of a subsea sensor, and the first housing portion may be sealed against a pipe section, for example a pipeline section or a flow duct in a Christmas tree or the like. The first housing portion may comprise a mounting flange for mounting the subsea housing assembly to such metal body.

A key advantage of the invention described herein lies in the fact that no special wall design is required in order to facilitate the inductive coupling. A flat wall section may for example be chosen for mounting the inductive coupler.

### BRIEF DESCRIPTION OF THE DRAWINGS

Fig. 1 is a schematic diagram showing a subsea housing assembly and a subsea sensor wherein the wall is integrally formed with a housing body and the coils forming the inductive coupler are placed on either side of the wall as discussed in embodiments of EP 3269921.
Fig. 2 is a schematic diagram showing a subsea housing assembly mounted to a pipe section.
Figs. 3, 4, 5 and 6 show details of the subsea housing assembly's inductive coupler according to embodiments of the present invention.

### DETAILED DESCRIPTION

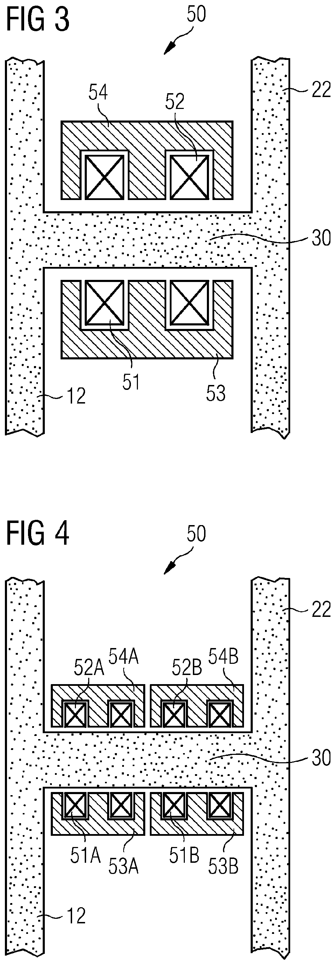

Fig. 1 is a schematic view of a subsea housing assembly 100 that is part of a subsea sensor 200. The subsea housing assembly 100 includes a first housing portion 10 and a second housing portion 20. The first housing portion 10 includes a first housing body 12 and a first chamber 11. The second housing portion 20 includes a second housing body 22 and a second chamber 21. The first and second housing bodies 12, 22 include flanges 18, 28, respectively, by means of which they are fixedly attached to each other. In the present example, both housing portions are bolted together. In other embodiments the housing bodies 12, 22 may form a single body such as shown for example in Figs. 3-6.

The first housing body 12 substantially surrounds the first chamber 11. In particular, the first housing portion 10 in-eludes a wall 30 that provides a pressure barrier. This allows a high pressure difference to be applied across the walls of the first housing body 12. The wall 30 provides separation between the first chamber 11 and the second chamber 21. Accordingly, a safe and reliable sealing can be provided between the first and second chambers 11, 21 that is capable of withstanding high pressure differences, for example in excess of 1,000 bar or even 2,000 bar (1 bar = 100 kPa).

At the other end, the first housing portion 10 may simply be closed, for example by means of a closing plate or the like. Such configuration may be employed when the subsea housing assembly 100 is used for a subsea canister, such as a subsea electronic canister or a control canister or control module. In the embodiment of Fig. 1, the subsea housing assembly 100 is used for a subsea sensor 200 and a first pressure barrier 17 is provided in the first housing portion 10. The first pressure barrier 17 provides sealing of the first chamber 11 towards a part of the first housing portion 10 in which a sensor element 61 is located and exposed to high pressures, such as the high pressure of a process fluid. Note that such exposure may be a direct exposure, or an indirect exposure, for example via a respective process diaphragm and a pressure transmission fluid such as oil or the like.

When embodied as subsea sensor as in Fig. 1, the first chamber 11 may comprise sensor electronics 62, such as control electronics, data processing electronics and the like. The first chamber 11 may be a pressure resistant chamber in which a predefined pressure is maintained, even when the subsea housing assembly 100 is installed at a subsea location. Such pressure may be a pressure below 10 bar, it may preferably be a pressure below 5 bar, or even below 1.5 bar. A close to atmospheric pressure may prevail in the first chamber 11, which may thus be termed an atmospheric chamber. Chamber 11 may be filled with a gas, such as nitrogen, or a gas mixture, such as air or a mixture of nitrogen with other gasses. It may thus be possible to operate conventional electric and electronic components within chamber 11.

Accordingly, in the configuration of the subsea housing assembly as illustrated in Fig. 1, high pressures, such as of a process fluid, can effectively be confined to within the first chamber 11, even if the first pressure barrier 17 fails. The first pressure barrier 17 may for example comprise a feed through for an electric connection to the sensor element 61, or the sensor element 61 may itself be configured so as to constitute a pressure barrier. Under certain conditions, such pressure barrier may fail, thus allowing high pressure fluid to enter chamber 11. Wall 30 is constructed such that it provides a second barrier so that the pressure can be confined effectively within the first housing portion 10.

For providing a data communication with an electronic component within the first housing section 10 across wall 30, an inductive coupler 50 comprising a first coupling section 51 and a second coupling section 52 is provided. The inductive coupler and the wall section through which the coupling is effected are shown in Fig. 1 in terms of functional blocks only and will be explained in more detail below with reference to Figs. 3 to 6.

The first coupling section 51 is disposed in the first chamber 11 and connected to an electrical connection 15 that provides at least data communication, in particular with the sensor element 61 or the sensor electronics 62 in the example of Fig. 1. The second coupling section 52 is disposed in the second chamber 21 and is connected to a second electrical connection 25 in the second housing portion 20. The inductive coupler 50 provides at least data communication between the first and second electrical connections 15, 25 across the wall 30. Besides transmitting data communications, the coupler 50 may also be configured to transfer power from the electrical connection 25 to the electrical connection 15.

Guide bodies 53, 54 (not shown in Fig. 1) are provided and are formed and arranged such that a guiding of the magnetic flux created the coupling sections 51, 52 to the respective other coupling section is effected. In the preferred embodiment the wall 30 is made of a non-magnetic metal such as Iconel 625 which is often used to construct housings for subsea components. The guide bodies 53, 54 are made of a soft magnetic material such as ferrite which has a high permeability combined with a high bulk resistance.

The first and second coupling sections 51, 52 may for example be implemented as coils which are preferably arranged coaxially or concentrically. An alternating current (AC) provided to the second coupling section 52 may for example create a alternating magnetic field which is guided by a the second guide body 54 towards the first coupling section 51 to therein induce a current which then may be used to provide electric power to electric and electronic components comprised in the first housing portion 10, including sensor electronics 62 and sensor element 61. For data transmission, modulation may be provided. As an example, the current applied to the coil 52 may be modulated, and such modulation will lead to a modulation of the magnetic field, in turn leading to a modulation of the current induced in the first coupling section 51. For this purpose, a receiver/transmitter 56 can be provided in the second housing portion 20 and can be coupled to the second electrical connection 25. Unit 56 may include a receiver and a transmitter, and it may modulate control signals received on line 41 for transmission via the inductive coupler 50, and it may demodulate signals received from the second coupling section 52 for further transmission via the line 41. Note that the transmitter/receiver 56 may also be located at a different position, for example at the other end of line 41, at a topside location, or at a subsea data processing hub.

Similarly, a transmitter/receiver 55 is provided in the first housing portion 10 in chamber 11 and is connected to the first electrical connection 15 and the first coupling section 51. Unit 55 may for example detect a modulation of a current received from the first coupling section 51 and may provide corresponding control signals to the sensor electronics 62. Unit 55 may further receive sensor data from the sensor electronics 62 and may modulate such sensor data onto a signal that is provided to the first coupling section 51, so that an alternating magnetic field is created and guided by the first guide body towards the second coupling section 52 and induces an alternating current therein that is detected and demodulated by transmitter/receiver unit 56. Accordingly, data recorded by the sensor element 61 can be communicated on line 41, without requiring electric wires that penetrate wall 30 which provides the secondary pressure barrier.

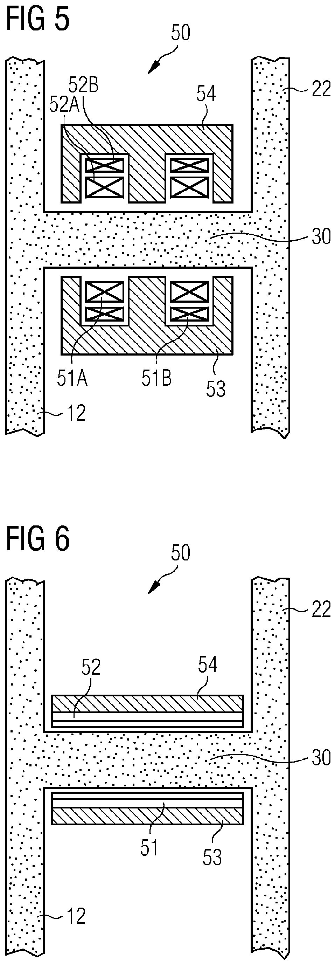

Inductive couplers 51 and 52 may comprise plural coupling sections, for example some dedicated to the transfer of electrical power and others dedicated to the transfer of data communications as shown for example in Figs. 4 and 5.

As the pressure is confined to within the first housing portion 10 by means of wall 30, the sealing of the second housing portion 20 is facilitated. In particular, the second chamber 21 can be a pressure compensated chamber the pressure of which is balanced to the surrounding ambient pressure, in particular the subsea pressure when the housing assembly 100 is installed subsea. The differential pressure across the walls of the second housing body 22 is accordingly relatively low. In the example of Fig. 1, the housing body 22 has an opening in which the second coupling section 52 is located. This opening is sealed against the first housing body 12, for example by means of O-ring seals 29. Double seals are preferably provided.

The second chamber 21 may be filled with a substantially incompressible medium, in particular a dielectric liquid or gel, such as oil or the like. The electric and electronic components of the unit 56 can be adapted to operate in such environment, or, as mentioned above, unit 56 may be located outside chamber 21, for example in a subsea canister to which the sensor 200 is connected, or topside. Pressure compensation can occur by means of a dedicated pressure compensator forming part of the subsea housing assembly 100 (not shown). In other embodiments, the subsea housing assembly 100 may be connected to a subsea cable in form of an oil filled hose, wherein the inner volume of such hose is filled with a dielectric liquid (in particular oil) and is pressure compensated against the ambient environment due to the flexibility of the hose. Pressure compensation of the second chamber 21 can occur via such hose, for example by allowing a flow communication through the opening 26 between the inner volume of the hose and the chamber 21, or by providing some pressure transmitting element in the opening, such as a membrane or bellows.

In other configurations the second chamber 21 may be a pressure resistant chamber. As an example, a predefined pressure below 10 bar, preferably below 5 bar or below 1.5 bar, such as close to atmospheric pressure may be maintained in chamber 21. For this purpose, another wall comprising another inductive coupler or a standard penetrator providing a pressure barrier (not shown) can be provided in the opening 26. Since such wall has to withstand the differential pressure between the interior pressure of chamber 21 and the external subsea pressure when installed subsea, the pressure difference is usually lower compared to the pressure difference that can prevail at barriers potentially exposed to the pressure of process fluid.

The second housing portion 20 may for example comprise a fitting or connector for providing a connection to a subsea cable. In other configurations, a further unit, such as a control module or the like, may be mounted directly to the subsea housing assembly 100.

By providing the inductive coupler 50, problems related to insulation resistance that occur with conventional glass penetrators may be overcome. In particular, the insulation resistance would in such case be measured between the metal cage provided by the first and second housing bodies 12, 22 and the respective coupling section 51, 52, so that insulation resistance can be kept high. In particular, since no glass penetrators are used, the insulation resistance can also be maintained during high pressure testing.

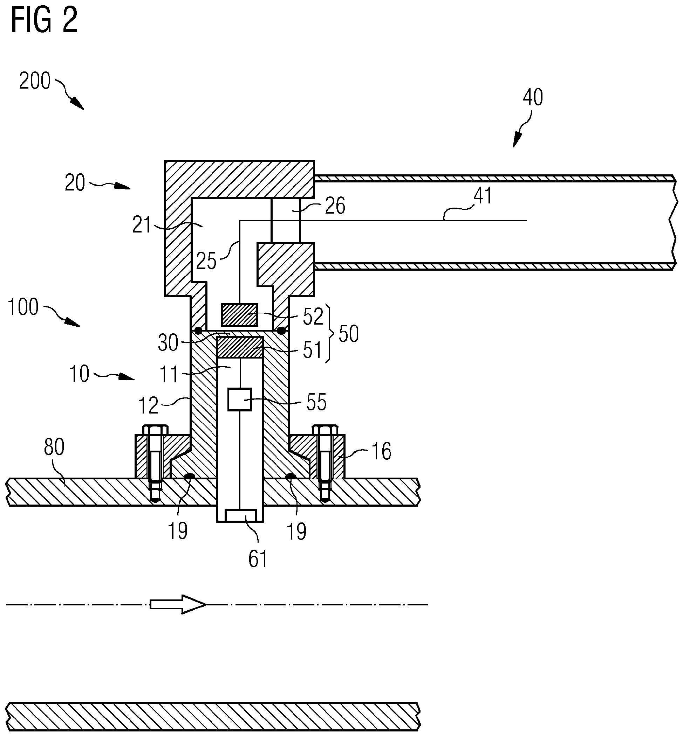

In Fig. 2, an embodiment of a subsea housing assembly 100 that is part of an embodiment of a subsea sensor 200 is illustrated. The explanations provided above with respect to Figs. 1, 3, 4 and 5 are equally applicable to the embodiment of Fig. 2. In Fig. 2, the subsea housing assembly 100 is mounted to a subsea pipe 80 through which a process fluid flows. As shown the first housing body 12 is pressed against the subsea pipe 80 by means of the mounting flange 16 and sealed by means of the seal 19 which may for example be a metal gasket. Note that two seals 19 may be provided to provide a double barrier.

Sensor element 61 may for example measure the temperature and/or the pressure of the process fluid flowing through the pipe section 80, and respective readings may be modulated and transmitted by the transmitter/receiver 55 via the inductive coupler 50.

To the port opening 26 of the second housing portion 20, a subsea cable in form of an oil filled hose 40 is mounted. Note that the subsea cable may form part of the subsea sensor 200 and that a (wet mate or dry mate) connector may be provided at the other end of the subsea cable 40 for connecting the sensor 200 to another subsea device or to a topside installation. In the example of Fig. 2 line 41 of subsea cable 40 is directly connected to electrical connection 25 and second coupling section 52. It will be apparent to those with skills in the art that in other embodiments further electric and electronic components such as the transmitting/receiving unit 56 can be provided. Again, it is noted that the opening 26 may in some embodiments allow a flow communication between the interior of subsea cable 40 and the second chamber 21, while in other embodiments separation may be provided. Such separation can be provided by a pressure transmitting element such as a membrane, or by means of a penetrator or another inductive coupler which allows maintaining a pressure difference across the opening 26.

In Fig. 3 there are shown further details of a first preferred embodiment of the present invention. Again, the explanations provided above with respect to Figs. 1 and 2 apply mutatis mutandis to the embodiment shown in Fig. 3 and only the differences and improvements are discussed in the following.

In the embodiment shown in Fig. 3 the first and second coupling sections 51, 52 are shown to be implemented as coils which are preferably arranged coaxially or concentrically. The first coil 51 is mounted with a small gap on one side of wall 30 and the second coil 52 is mounted with a small gap on the other side of wall 30. In other embodiments there may be no gap between the coils 51, 52 and wall 30. A first guide body 53 is placed on the first coil 51, or the first coil is placed inside the first guide body which is then mounted. The first guide body 53 preferably encloses the first coil 51 except where the first coil faces the wall 30 so as to capture as much of the magnetic field emanating from the first coil 51 as possible and direct the same through the wall 30 towards the second coil 52, thereby utilizing more of the generated field and thus increasing the efficiency inductive coupler.

A preferred shape for the first guide body 53 is known as the pot core. More precisely, essentially half a pot core is used for the first guide 53, with the second guide body 54 essentially providing the other half. Such pot cores are well known to those with skills in the art. Sample shapes are for example shown in https://en.wikipedia.org/wiki/Magnetic_core#Pot_core.

Similarly, a second guide body 54 is placed on the second coil 52. The second guide body 54 preferably encloses the second coil 52 except where the second coil faces the wall 30 so as to capture as much of the magnetic field emanating from the second coil 52 as possible and direct the same through the wall 30 to the first coil 51. It should be noted that the two guide bodies 53, 54 form an overall guide body for guiding the magnetic flux or field in that the guide body at the receiving coil directs the flux or field received through the wall towards the receiving coil.

Preferably essentially the same shape is used for both guide bodies and both guide bodies are preferably arranged concentrically or coaxially and symmetrical with reference to wall 30. Such symmetry makes for easier production and the most homogenous distribution of the magnetic field.

Another preferred shape for the guide bodies 53, 54 is known as the "E" core. Variants of the "E" core are known as the EFD core or the ETD core. Sample "E" cores are for example shown in https://en.wikipedia.org/wiki/Magnetic_core#"E"_core.

It should be noted that the pot core may be preferable because it may capture the magnetic field emanating from the coils more completely. On the other hand a pot core requires more space and it may thus be preferable to implement an "E" core depending on a given housing or wall design.

Turning now to Fig. 4 there is shown an arrangement comprising two coil systems A, B for providing electrical signals or power across the wall 30. Again, the explanations provided above with respect to Figs. 1, 2 and 3 apply mutatis mutandis to the embodiment shown in Fig. 4 and only the differences and improvements are discussed in the following.

A first coil system A comprises a first coil 51A, a second coil 52A, a first guide body 53A, and a second guide body 54A which may be configured as described with reference to Fig. 3. A second coil system B comprising first coil 51B, a second coil 52B, a first guide body 53B, and a second guide body 54B may be implemented similar to or different from the first coil system A. In the example shown in Fig. 3 the outer dimensions of both coil systems are similar. The coils in both systems may be similar or different, for example by having a similar or different numbers of windings resulting in similar or different inductances.

A single coil set, as discussed above with reference to Figs. 1, 2 and 3, may generally be sufficient to transmit data and power into and data out of the first chamber 11, for example by employing a time multiplex scheme. Providing a second set of coils provides a variety of additional design choices. For example distinct paths (and adapted coil sets) may be provided for transmitting power and/or control data into the first chamber and/or for transmitting sensor data out of the first chamber. For example, coil set A may be adapted for transmitting power into the first chamber 11 and coil set B may be adapted for transmitting data out of the first chamber 11. In such a configuration it may be advantageous to adapt the parameters of the coil sets in accordance with what they need to transmit (power or data).

In other embodiments the second coil set may be provided as a redundancy measure, noting that subsea sensors and connectors typically need to be designed for extremely long lifetimes, e.g. in excess of 20 or 30 years.

In the embodiment shown in Fig. 4 the coil sets A and B are shown to be arranged next to each other. In other embodiments the coil sets may also be arranged around the same cores, as for example shown in Fig. 5, where the coils of the coil sets share the guide bodies. In more detail, the first coils 51A, 51B of the coil sets A and B are mounted inside the first guide body 53 and the second coils 52A, 52B of the coil sets A and B are mounted inside the second guide body 54. The coils may be similar or different, for example by having a similar or different numbers of windings resulting in similar or different inductances.

The advantage of the arrangement shown in Fig. 5 is that the available space can by utilized for large guide bodies whereas in the arrangement shown in Fig. 4 the guide bodies need to share the available space. The parameters of the coil sets may be adapted to the coil's purpose. For example the first coil set A may be dedicated to the energy transmission and may be adapted to have a bigger inductance so as to allow better transmissions at low frequencies.

It should be noted however that in the arrangement of Fig. 5 there is no channel separation between the coil sets A and B, i.e. the magnetic fields of the coil sets interfere and separation has to be provided by way of signal processing such as modulation and/or filtering.

Turning now to Fig. 6 there is shown an arrangement suitable for thinner walls comprising planar coils 51, 52 manufactured in a most cost effective manner using PCB manufacturing processes. The guide bodies 53, 54 are flat and placed on the PCB coils. With this method multiple coils (i.e. multiple channels) may be realized on one PCB substrate at very low extra cost. The transmission may preferably be effected using higher frequencies, for example frequencies above 10kHz or even above 100kHz, in some configurations even above 1MHz. The guide bodies may be wrapped around the edges of the PCB (not shown).

As is well known the planar guide bodies may in embodiments be shaped so as to enhance the guiding of the magnetic field, for example by providing a planar "E" core. Sample shapes are for example shown in https://en.wikipedia.org/wiki/Magnetic_core#Planar_core.

It should be noted that other, i.e. non-PCB, planar (or flat) coils may also be employed which generally provide higher inductances but maintain the low planar profile where the height of the inductive coupler structure is limited.

Experiments have shown that it may be preferable to optimize the design of the guide bodies by choosing the largest possible outer dimensions (e.g. outer diameter of the pot in a pot core) and the smallest possible inner core dimension so as to maximize the distance between the outer rim and inner part of the guide structure.

It should be noted that while metal housings are commonly used in subsea application the present invention is equally applicable to embodiments employing non-metallic housings or non-metallic walls 30.

The subsea housing assembly 100 is described above primarily with respect to the use in a subsea sensor 200 which may be attached to a pipe section exposed to process fluid pressures of 1000 bar or more, yet it is to be understood that it may also be used in other applications, in particular where the integrity of a pressure barrier is of importance but where the operating pressures are lower, for example in other subsea equipment such as connectors or canisters exposed to seawater pressures of approximately 100 bar at 1000 m water depth or approximately 300 bar at 3000 m water depth. Electrical penetrators are a key design concern, particularly for connectors, and with the present invention it may be possible to replace at least some of the electrical penetrators by an inductive penetrator enclosed in a subsea housing in accordance with the present invention. Other applications may include the application in a subsea control unit where the integrity of a one atmospheric chamber needs to be ensured. Other applications are equally conceivable.

While specific embodiments are disclosed herein, various changes and modifications can be made without departing from the scope of the invention. The present embodiments are to be considered in all respects as illustrative and non restrictive, and all changes coming within the meaning of the appended claims are intended to be embraced therein.

## Claims

1. A subsea housing assembly, comprising:
- a subsea housing;
- a first housing portion (10) of the subsea housing, wherein the first housing portion (10) comprises a first electrical connection (15) for data communication and at least a first chamber (11), wherein the first chamber (11) is a pressure resistant chamber in which a predetermined pressure is maintained when the subsea housing assembly (100) is installed subsea;
- a second housing portion (20) of the subsea housing, wherein the second housing portion (20) comprises a second electrical connection (25) for data communication and at least a second chamber (21), wherein the second chamber (21) is a pressure compensated chamber that is pressure balanced against an ambient seawater pressure when the subsea housing assembly (100) is installed subsea;
- a wall (30) providing separation between the first chamber (11) and the second chamber (21); and
- an inductive coupler (50) comprising a first coupling section (51) disposed in the first chamber (11) and a second coupling section (52) disposed in the second chamber (12), wherein the inductive coupler (50) is configured to provide inductive coupling across the wall (30) for providing at least a data communication between the first electrical connection (15) in the first housing portion (10) and the second electrical connection (25) in the second housing portion (20); wherein
- a first guide body (53) made of soft magnetic material is provided for collecting and guiding the magnetic flux created by the first coupling section to the second coupling section; and
- a second guide body (54) made of soft magnetic material is provided for collecting and guiding the magnetic flux created by the second coupling section to the first coupling section.

2. The subsea housing assembly according to claim 1, wherein the wall (30) is a pressure barrier configured to resist a predetermined minimum pressure difference across the wall (30) .

3. The subsea housing assembly according to claim 1 or 2, wherein the inductive coupler (50) is further configured to inductively supply electrical power from the electrical connection (25) in the second housing portion (20) to the electrical connection (15) in the first housing portion (10).

4. The subsea housing assembly according to any of the preceding claims, wherein a pressure of less than 10 bar is maintained in the first chamber (11) when the subsea housing assembly (100) is installed subsea.

5. The subsea housing assembly according to any of the preceding claims, wherein the subsea housing is a subsea housing of a subsea electrical device (200), wherein electric and/or electronic components of the subsea electrical device (200) are disposed in the first chamber (11).

6. The subsea housing assembly according to any of the preceding claims, wherein the wall (30) is integrally formed with a first housing body (12) of the first housing portion (10), wherein the first housing body (12) is preferably a single piece metal body.

7. The subsea housing assembly according to any of the preceding claims, wherein the first and second coupling sections (51, 52) comprise coils that are arranged concentrically or coaxially.

8. The subsea housing assembly according any of the preceding claims, wherein the guide bodies (53, 54) comprise pot core halves.

9. The subsea housing assembly according to any of claims 1 to 7, wherein the guide bodies (53, 54) comprise "E" cores.

10. The subsea housing assembly according to claim 7, wherein the coils are flat PCB coils and wherein the guide bodies are flat.

11. The subsea housing assembly according to any of the preceding claims, wherein the wall is made of a non-magnetic material, preferably a non-magnetic metal, preferably Iconel 625.

12. A subsea sensor comprising a subsea housing assembly (100) according to any of the preceding claims, wherein the subsea sensor (200) comprises a sensor element (61) disposed in the first housing portion (10), wherein the first electrical connection (15) is configured for providing communication with the sensor element (61), and wherein the second electrical connection (25) is configured to provide at least a sensor output of the subsea sensor (200).

13. A subsea connector comprising a subsea housing assembly (100) according to any of claims 1 to 11.

## Patentansprüche

1. Untersee-Gehäusebaugruppe, die Folgendes umfasst:
- ein Untersee-Gehäuse,
- einen ersten Gehäuseabschnitt (10) des Untersee-Gehäuses, wobei der erste Gehäuseabschnitt (10) eine erste elektrische Verbindung (15) für den Datenaustausch und zumindest eine erste Kammer (11) umfasst, wobei es sich bei der ersten Kammer (11) um eine druckfeste Kammer handelt, in der ein vorgegebener Druck aufrechterhalten wird, wenn die Untersee-Gehäusebaugruppe (100) unterseeisch installiert ist,
- einen zweiten Gehäuseabschnitt (20) des Untersee-Gehäuses, wobei der zweite Gehäuseabschnitt (20) eine zweite elektrische Verbindung (25) für den Datenaustausch und zumindest eine zweite Kammer (21) umfasst, wobei es sich bei der zweiten Kammer (21) um eine druckentlastete Kammer handelt, die gegenüber einem Meereswasserumgebungsdruck druckausgeglichen ist, wenn die Untersee-Gehäusebaugruppe (100) unterseeisch installiert ist,
- eine Wand (30), die für eine Trennung zwischen der ersten Kammer (11) und der zweiten Kammer (21) sorgt, und
- einen induktiven Koppler (50), der ein in der ersten Kammer (11) angeordnetes erstes Kopplungssegment (51) und ein in der zweiten Kammer (12) angeordnetes zweites Kopplungssegment (52) umfasst, wobei der induktive Koppler (50) so konfiguriert ist, dass er zum Ermöglichen eines Datenaustauschs zumindest zwischen der ersten elektrischen Verbindung (15) in dem ersten Gehäuseabschnitt (10) und der zweiten elektrischen Verbindung (25) in dem zweiten Gehäuseabschnitt (20) über die gesamte Wand (30) hinweg für eine induktive Kopplung sorgt, wobei
- ein erster Führungskörper (53) aus weichmagnetischem Material zum Aufnehmen und Leiten des von dem ersten Kopplungssegment erzeugten Magnetflusses zu dem zweiten Kopplungssegment vorgesehen ist und
- ein zweiter Führungskörper (54) aus weichmagnetischem Material zum Aufnehmen und Leiten des von dem zweiten Kopplungssegment erzeugten Magnetflusses zu dem ersten Kopplungssegment vorgesehen ist.

2. Untersee-Gehäusebaugruppe nach Anspruch 1,
wobei es sich bei der Wand (30) um eine Druckbarriere handelt, die so konfiguriert ist, dass sie einer vorgegebenen Mindestdruckdifferenz an der Wand (30) standhält.

3. Untersee-Gehäusebaugruppe nach Anspruch 1 oder 2,
wobei der induktive Koppler (50) ferner so konfiguriert ist, dass er induktiv Strom aus der elektrischen Verbindung (25) in dem zweiten Gehäuseabschnitt (20) zur elektrischen Verbindung (15) in dem ersten Gehäuseabschnitt (10) leitet.

4. Untersee-Gehäusebaugruppe nach einem der vorhergehenden Ansprüche,
wobei in der ersten Kammer (11) ein Druck von weniger als 10 bar aufrechterhalten wird, wenn die Untersee-Gehäusebaugruppe (100) unterseeisch installiert ist.

5. Untersee-Gehäusebaugruppe nach einem der vorhergehenden Ansprüche,
wobei es sich bei dem Untersee-Gehäuse um ein Untersee-Gehäuse einer unterseeischen elektrischen Vorrichtung (200) handelt,
wobei elektrische und/oder elektronische Komponenten der unterseeischen elektrischen Vorrichtung (200) in der ersten Kammer (11) angeordnet sind.

6. Untersee-Gehäusebaugruppe nach einem der vorhergehenden Ansprüche,
wobei die Wand (30) an einen ersten Gehäusekörper (12) des ersten Gehäuseabschnitts (10) angeformt ist, wobei es sich bei dem ersten Gehäusekörper (12) vorzugsweise um einen einstückigen Metallkörper handelt.

7. Untersee-Gehäusebaugruppe nach einem der vorhergehenden Ansprüche,
wobei das erste und das zweite Kopplungssegment (51, 52) Spulen umfassen, die konzentrisch oder koaxial angeordnet sind.

8. Untersee-Gehäusebaugruppe nach einem der vorhergehenden Ansprüche,
wobei die Führungskörper (53, 54) Topfkernhälften umfassen.

9. Untersee-Gehäusebaugruppe nach einem der Ansprüche 1 bis 7,
wobei die Führungskörper (53, 54) "E"-Kerne umfassen.

10. Untersee-Gehäusebaugruppe nach Anspruch 7, wobei es sich bei den Spulen um Leiterplatten-Flachspulen handelt und die Führungskörper flach sind.

11. Untersee-Gehäusebaugruppe nach einem der vorhergehenden Ansprüche,
wobei die Wand aus einem nichtmagnetischen Material, vorzugsweise einem nichtmagnetischen Metall, vorzugsweise Iconel 625, hergestellt ist.

12. Untersee-Sensor, der eine Untersee-Gehäusebaugruppe (100) nach einem der vorhergehenden Ansprüche umfasst,
wobei der Untersee-Sensor (200) ein Sensorelement (61) umfasst, das in dem ersten Gehäuseabschnitt (10) angeordnet ist, wobei die erste elektrische Verbindung (15) für das Ermöglichen einer Kommunikation mit dem Sensorelement (61) und die zweite elektrische Verbindung (25) zum Bereitstellen zumindest einer Sensorausgabe des Untersee-Sensors (200) konfiguriert ist.

13. Unterseeischer Verbinder, der eine Untersee-Gehäusebaugruppe (100) nach einem der Ansprüche 1 bis 11 umfasst.

## Revendications

1. Ensemble à boîtier sous-marin, comprenant
- un boîtier sous-marin ;
- une première partie (10) de boîtier du boîtier sous-marin, étant entendu que la première partie (10) de boîtier comprend une première connexion électrique (15) pour la communication de données et au moins une première chambre (11), la première chambre (11) étant une chambre résistant à la pression dans laquelle une pression prédéterminée est maintenue quand l'ensemble (100) à boîtier sous-marin est installé sous l'eau ;
- une deuxième partie (20) de boîtier du boîtier sous-marin, étant entendu que la deuxième partie (20) de boîtier comprend une deuxième connexion électrique (25) pour la communication de données et au moins une deuxième chambre (21), la deuxième chambre (21) étant une chambre à compensation de pression dont la pression est équilibrée par rapport à une pression ambiante de l'eau de mer lorsque l'ensemble (100) à boîtier sous-marin est installé sous l'eau ;
- une paroi (30) assurant la séparation entre la première chambre (11) et la deuxième chambre (21), et
- un coupleur inductif (50) comprenant une première section de couplage (51) disposée dans la première chambre (11) et une deuxième section de couplage (52) disposée dans la deuxième chambre (12), étant entendu que le coupleur inductif (50) est configuré pour assurer un couplage par induction à travers la paroi (30) afin d'assurer au moins une communication de données entre la première connexion électrique (15), dans la première partie (10) de boîtier, et la deuxième connexion électrique (25), dans la deuxième partie (20) de boîtier, étant entendu :
- qu'un premier corps de guidage (53) fait en matériau magnétique doux est prévu pour recueillir et guider le flux magnétique créé par la première section de couplage jusqu'à la deuxième section de couplage, et
- qu'un deuxième corps de guidage (54) fait en matériau magnétique doux est prévu pour recueillir et guider le flux magnétique créé par la deuxième section de couplage jusqu'à la première section de couplage.

2. Ensemble à boîtier sous-marin selon la revendication 1, étant entendu que la paroi (30) est une barrière à la pression configurée pour résister à une différence de pression minimale prédéterminée de part et d'autre de la paroi (30).

3. Ensemble à boîtier sous-marin selon la revendication 1 ou 2, étant entendu que le coupleur inductif (50) est par ailleurs configuré pour fournir par induction de l'énergie électrique depuis la connexion électrique (25), dans la deuxième partie (20) de boîtier, à la connexion électrique (15), dans la première partie (10) de boîtier.

4. Ensemble à boîtier sous-marin selon l'une quelconque des revendications précédentes, étant entendu qu'une pression de moins de 10 bars est maintenue dans la première chambre (11) lorsque l'ensemble (100) à boîtier sous-marin est installé sous l'eau.

5. Ensemble à boîtier sous-marin selon l'une quelconque des revendications précédentes, étant entendu que le boîtier sous-marin est un boîtier sous-marin d'un dispositif électrique sous-marin (200), des composants électriques et/ou électroniques du dispositif électrique sous-marin (200) étant disposés dans la première chambre (11).

6. Ensemble à boîtier sous-marin selon l'une quelconque des revendications précédentes, étant entendu que la paroi (30) est faite d'un seul tenant avec un premier corps (12) de boîtier de la première partie (10) de boîtier, le premier corps (12) de boîtier étant de préférence un corps métallique d'une seule pièce.

7. Ensemble à boîtier sous-marin selon l'une quelconque des revendications précédentes, étant entendu que les première et deuxième sections de couplage (51, 52) comprennent des bobines qui sont agencées de façon concentrique ou coaxiale.

8. Ensemble à boîtier sous-marin selon l'une quelconque des revendications précédentes, étant entendu que les corps de guidage (53, 54) consistent en moitiés de pot de ferrite.

9. Ensemble à boîtier sous-marin selon l'une quelconque des revendications 1 à 7, étant entendu que les corps de guidage (53, 54) consistent en noyaux en E.

10. Ensemble à boîtier sous-marin selon la revendication 7, étant entendu que les bobines sont des bobines plates à circuits imprimés et que les corps de guidage sont plats.

11. Ensemble à boîtier sous-marin selon l'une quelconque des revendications précédentes, étant entendu que la paroi est faite en un matériau non magnétique, de préférence un métal non magnétique, de préférence de l'Iconel 625.

12. Capteur sous-marin comprenant un ensemble (100) à boîtier sous-marin selon l'une quelconque des revendications précédentes, étant entendu que le capteur sous-marin (200) comprend un élément capteur (61) disposé dans la première partie (10) de boîtier, que la première connexion électrique (15) est configurée pour assurer la communication avec l'élément capteur (61) et que la deuxième connexion électrique (25) est configurée pour assurer au moins une sortie de capteur du capteur sous-marin (200).

13. Connecteur sous-marin comprenant un ensemble (100) à boîtier sous-marin selon l'une quelconque des revendications 1 à 11.
